# EUROPEAN PATENT SPECIFICATION

(11) **EP 0 351 139 B1**
(45) Date of publication and mention of the grant of the patent: **15.09.1993**
(21) Application number: 89306878.3
(22) Date of filing: 06.07.1989
(51) Int. Cl.: H01L 39/24

(54) **Method of making composite ceramic and copper superconducting elements**
Methode zur Herstellung zusammengesetzter keramischer und kupferhaltiger supraleitender Elemente
Méthode de réalisation de composites supraconducteurs en céramique et cuivre

(30) Priority: 12.07.1988 US 217925
(43) Date of publication of application: 17.01.1990
(73) Proprietor: International Business Machines Corporation, Armonk, N.Y. 10504 (US)
(72) Inventor: Engler, Edward Martin, San Jose, CA 95123 (US); Kodas, Toivo Tarmo, Alburquerque N.M. 87111 (US); Lee, Victor Yee-Way, San Jose, CA 95120 (US)
(74) Representative: Atchley, Martin John Waldegrave

(56) References cited:
- APPLIED PHYSICS LETTERS, vol. 52, no. 19, 9th May 1988, pages 1622-1624, American Institute of Physics, New York, US; T.T. KODAS et al.: "Aerosol flow reactor production of fine Y1Ba2Cu3O7 powder: Fabrication of superconducting ceramics"
- PROGRESS IN HIGH TEMPERATURE SUPERCONDUCTIVITY & PROCEEDINGS WORLD CONGRESS ON SUPERCONDUCTIVITY, Houston, 20th-24th February 1988, vol. 8, pages 177-183; T.T. KODAS et al.: "Aerosol flow reactor production of Y1Ba2Cu3O7 powder"
- MATERIALS RESEARCH BULLETIN, vol. 23, no. 9, September 1988, pages 1337-1344, Pergamon Press, New York, US; A. PEBLER et al.: "Synthesis of a small particle size YBa2Cu3O7-x by a vapor phase process"

## Description

The present invention is concerned with a method of making composite ceramic and copper superconducting elements.

The following publications describe processes which are related to but distinct from the present invention.

Matsuda et al., Material Research Society Symposium Proc., V. 99, 1988, p. 695, shows a process for making silver-based wires.

Togano et al., Material Research Society Symposium Proc., V. 99, 1988, p. 191, shows a copper tape coated with a superconductor formed from a mixture of oxides.

Jin et al., Applied Physics Letter, V. 51(12), 21 September 1987, p. 943, shows a molten oxide process for forming superconductor wires.

Glowacki et al., Paper AA7.35 Materials Research Society Symposium Proceedings, Boston, 12/87, shows a composite superconductor based upon a outer cladding of silver.

McCallum et al., Advances in Ceramic Materials, May 1987, discuss problems in fabricating YBa₂Cu₃Oₓ superconducting wires.

Kohno et al., Yamada Conference on Superconductivity, published in Physica B, 148(1-3), p. 429, describe characteristics of high Tc oxide wires.

Ohmatsu et al., Japanese Journal of Applied Physics, 26, Supplement 26-3, L1207, 1987, show a method for making high Tc oxide wires.

None of the above publications appears to employ the manufacturing steps required by the present invention.

The key to many practical applications of the new high temperature ceramic superconductors is the ability to fabricate them into useful forms in a way that is compatible with other materials. Efforts to fabricate wires have been plagued by the brittle nature of these materials and their poor normal state resistivity. This has necessitated the use of more pliable metal supports which also act as a current shunt in case the superconductor transforms to its normal state.

The object of the present invention is to provide an improved method of making superconducting elements using copper and a superconducting ceramic.

According to the present invention, a composite ceramic and copper superconducting element is formed by the steps of (1) directing a submicron sized powder of a superconducting ceramic material over one surface of a piece of copper to coat the surface of said piece of copper with a uniform compact film of said powder, and (2) sintering said powder while passing oxygen over the surface coated with said powder and while maintaining the remaining surfaces of said piece of copper in an inert atmosphere.

The piece of copper may be a tube, the inner surface of which is coated with the ceramic material.

The method of the present invention is applicable to all ceramic superconductors. These materials have become very well known in the last few years. They include, for example, rare earth-based materials first discovered by the pioneering work of Bednorz and Muller, yttrium-based materials, thallium-based materials, and bismuth-based materials. All these ceramic superconductors comprise various metals and oxygen. They all share the common physical properties of ceramics, including brittleness and difficulty of fabrication. All such materials, however, are suitable for use in the method of the present invention.

The superconductivity properties of these materials are very dependent on the details of the manufacturing conditions. In particular, high temperature, oxygen-atmosphere sintering is essential to achieve optimum, bulk superconducting behaviour which makes manufacture of composite structures with other more reactive materials very difficult.

In order that the invention may be more readily understood an embodiment will now be described.

In one arrangement, sub micron sized powder is formed by an aerosol process. Such a process is described in Kodas et al., Applied Physics Letter 52 (19), 9 May 1988, p. 1622, which is incorporated herein by reference. As may be seen from this publication, submicron sized powder of a superconducting ceramic material is prepared by the steps of (1) forming submicron sized droplets of an aqueous solution containing the desired amounts of cations to form a high temperature superconductor, and (2) carrying said droplets in an oxygen flow through an oven at about 900-1,100°C to form a submicron sized powder which is superconducting.

As a typical illustration of the method of manufacture, a constant output atomizer is used to nebulise an aqueous solution of Y, Ba, and Cu nitrates. The nebuliser produces sub micron sized droplets that are carried in an oxygen flow through an oven at about 1,000°C. Emerging from the oven is a submicron (less than 0.5 micron) powder of Y₁Ba₂Cu₃O₇ superconductor. X-ray and susceptibility measurements confirm the formation of the superconductor. These fine powders when directed through a length of copper tubing will coat, under the proper temperature gradients, the inner walls to provide an uniform, compact film. The next step is to fix the Y₁Ba₂Cu₃O₇ powder to the copper by sintering it into a bulk superconductor. This is done by having the copper tube in an inert atmosphere (for example, Argon) and passing heated oxygen (700-900°C) through the inside of copper tube. This results in heating from the inside out and minimizes the reaction of copper with oxygen during sintering. The outer copper surface is protected from oxidation by the inert atmosphere.

Key features of the method being described are the use of very small particles (less than 0.5 microns) of the superconductor which are deposited on the copper tube by thermophoresis and Brownian diffusion to form a dense coating, the ability to move the deposition zone by controlling the temperature gradients, and the ability to heat only the inner tube surface in an oxygen atmosphere. In addition, these fine, high-purity powders produced in the aerosol flow reactor are more readily sintered under milder conditions. The process lends itself to large scale operations producing practical composite ceramic/copper wires of long length.

In another arrangement, an aqueous solution of the metal cation salts in the appropriate stoichiometry of the desired ceramic superconductor is passed through an aerosol generator in an oxygen flow to form fine droplets of the solution with an average diameter of 0.5-1.0 microns. A number of commercial aerosol generators are suitable including Collison nebulisers and ultrasonic nebulisers. The use of aqueous solutions of the nitrate salts eliminates the possibility of carbon contamination in the reacted powder from either the solvent or precursors. The droplets are passed through a dryer to remove the water. The dried particles are then carried in the flow stream through a furnace where the precursor compounds react with the oxygen carrier gas to form the superconducting powder. Since the particles come into contact with only water and the materials composing the aerosol generator, contamination problems in the superconductor powder are minimised. Particles with average diameters much less than a micron or as large as several microns can be produced by varying the initial aerosol droplet size and solution concentration. Narrow particle size distributions can be obtained by using aerosol generating systems incorporating a cyclone or impactor to remove particles above a chosen size.

Powder generation is carried out at temperatures from 900-1,100°C with reactor residence times of 10 - 100 seconds. Reactor residence time is controlled by the oven length and carrier gas flow rate. Typical oven lengths are 50 - 150 cm, and carrier gas flows are of from several litres per minute to several tens of litres per minute. Thermogravimetric analysis (TGA) indicated that more than 99% complete reaction can be obtained by optimising these reactor conditions. X-ray diffraction analysis of the reacted powders showed that single phase superconducting structures were prepared. Magnetic susceptibility measurements using a S.H.E VTS 920 SQUID magnetometer showed that the as-reacted powders were superconducting without further processing.

To produce a superconducting ceramic and copper composite wire, the particles in the oxygen carrier gas emerging from the reactor are sent into a copper tube where deposition takes place to coat the inside surface of the tube. By using very small particles (less than a micron in diameter) the superconducting material deposits on the surface of the tube by thermoporesis action and by Brownian diffusion to form a dense and uniform coating. For long lengths of copper tubing, uniformity of the coating can be controlled by placing the tubing in a temperature gradient. Because the coating mechanism involves diffusion, any surface or shape is readily coated.

After the desired amount of superconducting powder has been deposited, the coated copper tube is heated in the presence of an oxygen flow to the sintering temperature of the superconducting ceramic. Typically this corresponds to heating at temperatures ranging from 800-1,000°C for times ranging from several minutes to several hours, depending on the specific superconductor being used and the amount and the thickness of the material being sintered. Since copper is reactive in oxygen at elevated temperatures, a typical procedure is to heat the external area of the copper tube in an inert atmosphere such as nitrogen or argon, while passing an oxygen flow through the copper tube. Alternatively, preheated oxygen at the appropriate sintering temperature can be passed directly through the copper tube. Sintering produces an adherent superconducting film on the inside of the copper tube.

Since average particle diameters are of the order of 1 micron or less, tubes as small as 1 mm or less in diameter and as large as desired can be coated internally. The length of tube that can be coated is limited only in the sense that a longer tube requires a longer time to be coated to the required thickness. Uniformity in thickness along the copper tube length is provided by a temperature gradient. That is, at the inlet to the copper tube a higher temperature is maintained to reduce the deposition rate. Both straight and coiled tubes can be coated as well as flat surfaces that can be used to produce superconducting tapes.

Submicron particle deposition on the surface of the copper tube takes place by Brownian diffusion and thermophoresis, the relative contributions of these mechanisms being dictated by the operating conditions. Particle deposition by Brownian diffusion can be carried out at high temperatures thus allowing the simultaneous deposition and sintering of the particles. Particle deposition by thermophoresis depends on the radial temperature gradient in the gas flowing through the tube. This feature can be used to coat very long copper tubes. The location of this gradient along the tube length and the magnitude of the gradient can be controlled by varying the tube wall temperature. Thus, the location of the deposition zone can be moved along the length of a long copper tube to provide a uniform deposit.

When deposition is carried out at temperatures much below the sintering temperature for the material, sintering can be achieved by passing oxygen at approximately 800-1,000°C through the tube while exposing the outside of the tube to an inert gas. This allows sintering and subsequent annealing of the superconductor in the presence of oxygen thereby overcoming the need for oxygen diffusion through the copper tube walls in order to achieve the correct oxygen content in the superconductor. Since the material can be easily heated in the presence of oxygen once deposited, the particles that are used to form the deposit do not have to be superconducting. This allows the formation of composite ceramic and copper superconducting elements using manufacturing methods in which the aerosol particles themselves are not superconducting as long as diffusion and reaction in the deposited film result in the formation of a superconducting material.

The following examples are given solely for purposes of illustration, and are not to be considered limitations of the method of the present invention.

### Example 1 - Y₁Ba₂Cu₃Oₓ-copper wires:

A 0.03 M aqueous solution of yttrium nitrate, barium nitrate and copper nitrate with a molar ratio of 1:2:3 was passed through an aerosol generator producing 1-2 micron droplets. The aerosol was carried by an oxygen air stream at 3-10 litres per minute into a diffusion dryer to remove water vapour, and then entered a furnace (of approximate dimensions 10 cm diameter-100 cm length) at 900-1,000°C. At the exit from the furnace, the reaction chamber was directly coupled down to smaller diameter copper tubing. The diameter of the tubing was varied from one mm to 6.5 mm in typical experiments. Since the superconducting particles produced are submicron in size, their movement follows Brownian diffusion towards the inside wall of the tubing, depositing out as a smooth coating.

The coated superconductor was sintered by heating the copper tube in an inert atmosphere (i.e., argon or nitrogen) at 880°C while passing flowing oxygen through the tube for 60-120 minutes. This provided a continuous and electrically superconducting film on the inside of the copper tube. Four-point probe measurements, resistance vs. temperature, of this inside coating exhibit superconducting transitions with zero resistance at 90 K.

### Example 2 - La(1-x)SrxCuOy-copper wires (where x equals 0.1-0.25):

Prepared as above except starting with an aqueous solution of La, Sr and Cu nitrates, in the appropriate stoichiometry, passed through an aerosol generator. After sintering as above, an electrically superconducting coating was obtained with a zero resistance transition at 35°K.

### Example 3 - Bi2Sr2CaCu2Ox-copper wires:

Prepared as above except starting with an aqueous solution of Bi, Sr, Ca and Cu nitrates, in the appropriate stoichiometry, passed through an aerosol generator. The furnace temperature was between 850-900°C, and the sintering temperature was 800°C for 5 minutes. An electrically superconducting coating on copper was produced with a zero resistance transition at 80°K.

### Example 4 - T12-xBa2CaCu2Oy-copper wires (where x is variable from zero to 0.5):

Prepared as above except starting with an aqueous solution of Tl, Ba, Ca and Cu, in the stoichiometry of Tl 2, Ba 2, Ca 1, Cu 2. The furnace temperature was at 850-900°C, and the sintering temperature was 850°C for 30 minutes. A superconducting coating was produced with a transition at 110°K.

## Claims

1. A method of manufacturing a composite ceramic and copper superconducting element comprising the steps of (1) directing a submicron sized powder of a superconducting ceramic material over one surface of a piece of copper to coat the surface of said piece of copper with a uniform compact film of said powder, and (2) sintering said powder while passing oxygen over the surface coated with said powder and while maintaining the remaining surfaces of said piece of copper in an inert atmosphere.

2. A method as claimed in claim 1 comprising the steps of (1) forming submicron sized droplets of an aqueous solution containing the desired amounts of cations to form a high temperature superconductor; (2) carrying said droplets in an oxygen flow through an oven at about 900-1,100°C to form a submicron sized powder which is superconducting; (3) directing said powder over one surface of a piece of copper to coat said surface with a uniform compact film of said powder; and (4) sintering said powder while passing oxygen at 700-1,000°C over the surface coated with said powder and while maintaining the remaining surfaces of said piece of copper in an inert atmosphere.

3. A process as claimed in claim 1 or claim 2 in which said piece of copper is a copper tube and the inner surface of said tube is coated with said ceramic material.

4. A method as claimed in any one of the preceding claims wherein the ceramic material contains yttrium.

5. A method as claimed in any one of the preceding claims wherein the ceramic material contains thallium.

6. A method as claimed in any one of the preceding claims wherein the ceramic material contains bismuth.

7. A method as claimed in any one of the preceding claims wherein the ceramic material contains a rare earth element.

8. A method as claimed in claim 2 wherein the aqueous solution contains nitrates of the cations.

9. A composite ceramic and copper element manufactured by a method according to any one of the preceding claims.

## Patentansprüche

1. Eine Methode zur Herstellung eines zusammengesetzten keramischen und kupferhaltigen supraleitenden Elements, das folgende Schritte umfaßt: (1) Leiten eines submikroskopisch feinen Pulvers eines supraleitenden keramischen Materials über eine Oberfläche eines Kupferteils zur Beschichtung der Oberfläche des genannten Kupferteils mit einem gleichmäßigen kompakten Film des genannten Pulvers und (2) Sintern des genannten Pulvers, indem Sauerstoff über die mit dem genannten Pulver beschichtete Oberfläche geführt wird, während sich die übrigen Oberflächen des genannten Kupferteils in einer inerten Atmosphäre befinden.

2. Ein Verfahren gemäß Anspruch 1, das folgende Schritte umfaßt: (1) Bildung submikroskopisch kleiner Tröpfchen einer wäßrigen Lösung, die die gewünschten Mengen an Kationen enthält, um einen Hochtemperatur-Supraleiter zu bilden; (2) Führen der genannten Tröpfchen in einem Sauerstoffstrom durch einen Ofen bei etwa 900-1.100°C zur Bildung eines submikroskopisch feinen Pulvers, welches supraleitend ist; (3) Leiten des genannten Pulvers über eine Oberfläche eines Kupferteils, um die genannte Oberfläche mit einem gleichmäßigen kompakten Film des genannten Pulvers zu überziehen; und (4) Sintern dem genannten Pulvers, während Sauerstoff bei 700-1.000°C über die mit dem genannten Pulver beschichtete Oberfläche geleitet wird und während die übrigen Oberflächen des genannten Kupferteils sich in einer inerten Atmosphäre befinden.

3. Ein Verfahren gemäß Anspruch 1 oder Anspruch 2, in welchem das genannte Kupferteil ein Kupferrohr ist und die Innenfläche des genannten Rohrs mit dem genannten keramischen Material beschichtet wird.

4. Eine Methode gemäß jedem der vorherigen Ansprüche, in welcher das keramische Material Yttrium enthält.

5. Eine Methode gemäß jedem der vorherigen Ansprüche, in welcher das keramische Material Thallium enthält.

6. Eine Methode gemäß jedem der vorherigen Ansprüche, in welcher das keramische Material Bismut enthält.

7. Eine Methode gemäß jedem der vorherigen Ansprüche, in welcher das keramische Material ein seltenes Erdelement enthält.

8. Eine Methode gemäß Anspruch 2, in welcher die wäßrige Lösung Nitrate der Kationen enthält.

9. Ein zusammengesetztes keramisches und kupferhaltiges Element, das durch eine Methode gemäß jedem der vorherigen Ansprüche hergestellt wurde.

## Revendications

1. Un procédé de fabrication d'un élément supraconducteur composite de cuivre et de céramique, comprenant les étapes suivantes:
(1) l'application d'une poudre d'un matériau céramique supraconducteur dont les grains sont de dimensions inférieures au micron, sur une surface d'un morceau de cuivre pour recouvrir la surface dudit morceau de cuivre d'un film dense uniforme de ladite poudre, et
(2) le frittage de ladite poudre tout en passant de l'oxygène sur la surface recouverte de ladite poudre et tout en maintenant les surfaces restantes dudit morceau de cuivre dans une atmosphère inerte.

2. Un procédé selon la revendication 1 comprenant les étapes suivantes:
(1) la formation de gouttelettes d'une solution acqueuse de taille inférieure au micron, contenant les quantités désirées de cations, pour former un supraconducteur à haute température,
(2) le transport desdites gouttelettes dans un courant d'oxygène dans un four à une température de l'ordre de 900-1100°C pour former une poudre dont les grains ont une taille inférieure au micron et qui est supraconductrice,
(3) l'application de ladite poudre sur une surface d'un morceau de cuivre pour recouvrir ladite surface d'un film dense uniforme de ladite poudre, et
(4) le frittage de ladite poudre tout en passant de l'oxygène à une température de l'ordre de 700-1000°C sur la surface recouverte de ladite poudre et tout en maintenant les surfaces restantes dudit morceau de cuivre dans une atmosphère inerte.

3. Un procédé selon la revendication 1 ou la revendication 2 dans lequel ledit morceau de cuivre est un tube de cuivre et la surface intérieure dudit tube est recouverte dudit matériau céramique.

4. Un procédé selon l'une quelconque des revendications précédentes dans lequel le matériau céramique contient de l'yttrium.

5. Un procédé selon l'une quelconque des revendications précédentes dans lequel te matériau céramique contient du thallium.

6. Un procédé selon l'une quelconque des revendications précédentes dans lequel le matériau céramique contient du bismuth.

7. Un procédé selon l'une quelconque des revendications précédentes dans lequel le matériau céramique contient un élément de terre rare.

8. Un procédé selon la revendication 2 dans lequel la solution acqueuse contient des nitrates des cations.

9. Un élément composite de céramique et de cuivre fabriqué par l'exécution d'un procédé selon l'une quelconque des revendications précédentes.
